# EUROPEAN PATENT APPLICATION

(11) **EP 4 815 037 A1**
(43) Date of publication of application: **30.09.2026**
(21) Application number: 24893171.9
(22) Date of filing: 29.10.2024
(51) Int. Cl.: H01L 25/16, H01L 23/498, H01L 23/31

(54) **CHIP PACKAGE STRUCTURE AND CHIP PACKAGE METHOD**

(30) Priority: 21.11.2023 CN 202311562719; 01.08.2024 CN 202411054559
(71) Applicant: Vanchip (Tianjin) Technology Co. Ltd, Tianjin 300457 (CN)
(72) Inventor: ZHANG, Lei, Tianjin 300457 (CN); HONG, Shengping, Tianjin 300457 (CN); JIANG, Pinfang, Tianjin 300457 (CN); LIU, Zengtao, Tianjin 300457 (CN); ZHANG, Hua, Tianjin 300457 (CN); CHEN, Wen, Tianjin 300457 (CN)
(74) Representative: Patentship Patentanwaltsgesellschaft mbH
(86) International application number: PCT/CN2024/128009
(87) International publication number: WO 2025/108013

(57) **Abstract**

The present invention provides a chip package structure and a chip package method, in which a window in a first barrier layer exposes a substrate and a second solder pad in a non-filtering bearing region, as well as the substrate in a portion of a street region around the non-filtering bearing region, and a second barrier layer is formed on the first barrier layer in close proximity to an edge of the window. With this arrangement, a covering film is allowed to enclose a first hollow cavity under a filter chip while being able to be easily torn open along an interface of the second barrier layer and the window, resulting in the formation of a break therein, through which a plastic packaging layer can penetrate to fill the window and a second hollow cavity under a non-filter chip. This not only ensures proper operation of the filter chip, but also overcomes the problem of degraded reliability of the other device caused by insufficient underfilling by the encapsulating material, resulting in increased reliability of the chip package structure.

## Description

### TECHNICAL FIELD

The present invention relates to the field of chip packaging technology, and more particularly to a chip package structure and a chip package method.

### BACKGROUND

A surface acoustic wave (SAW) filter operates based on the propagation of acoustic waves along the surface of an associated chip. Therefore, the packaging of a SAW filter is required to ensure that the surface of an interdigital transducer (IDT) therein is not in contact with anything else. That is, it must be ensured that a hollow cavity is present on top of the chip. Otherwise, signal propagation may be adversely affected. SAW filterbased chip package structures may also incorporate common components that operate without depending on a hollow cavity, such as antenna switches, low-noise amplifiers (LNAs), capacitors and inductors.

For example, traditional diversity receiver (DRX) modules often incorporate a covering film, which blocks off an encapsulating material, ensuring the formation of a hollow cavity on top of a filter. However, due to the presence of the covering film, good underfilling of other devices in the module may not be attainable, possibly leading to shorting due to solder bridging. Moreover, reliability of the devices other than the filter could not be guaranteed, if their underfilling by the encapsulating material is incomplete. Therefore, there is a need in the art for further improving the reliability of such chip package structures.

### SUMMARY

It is an object of the present invention to overcome the problems of poor reliability with conventional chip package structures by presenting a novel chip package structure and chip package method.

To this end, the present invention provides a chip package structure including:
a substrate defining a filtering bearing region, a non-filtering bearing region and a street region surrounding the filtering bearing region and the non-filtering bearing region, the substrate formed thereon with a first solder pad and a second solder pad, the first solder pad located in the filtering bearing region, the second solder pad located in the non-filtering bearing region;
a first barrier layer formed on the substrate, the first barrier layer formed therein with a window and an opening, both extending through it across its thickness, the window exposing the substrate and the second solder pad in the non-filtering bearing region, as well as the substrate in a portion of the street region around the non-filtering bearing region, the opening exposing the first solder pad;
a second barrier layer formed on the first barrier layer in close proximity to an edge of the window;
a filter chip aligned with the filtering bearing region, which includes a first substrate, an interdigital transducer (IDT) formed on the first substrate and a first bump formed on the first substrate, and under which there is a first hollow cavity, the IDT facing the first barrier layer, the first bump electrically connected to the first solder pad;
a non-filter chip aligned with the non-filtering bearing region, which includes a second substrate and a second bump formed on the second substrate, and under which there is a second hollow cavity, the second bump electrically connected to the second solder pad, the second hollow cavity in communication with the window;
a covering film, which covers surfaces of the filter chip and the non-filter chip and the first and second barrier layers so as to enclose the first hollow cavity, and in which a break is formed in close proximity to the window; and
a plastic packaging layer, which covers a surface of the covering film and penetrates through the break to fill the window and the second hollow cavity.

Optionally, in the chip package structure, the covering film may have a thickness of H1, and particles in the plastic packaging layer may have a particle size of H2, wherein a projection of the non-filter chip on the substrate coincides with the non-filtering bearing region, and wherein at least one boundary of the window is spaced from respective at least one boundary of the non-filtering bearing region at a distance greater than or equal to H1 + 2H2.

Optionally, in the chip package structure, a projection of the non-filter chip on the substrate may coincide with the non-filtering bearing region, wherein at least one boundary of the window is spaced from respective at least one boundary of the non-filtering bearing region at a distance greater than or equal to 10 µm.

Optionally, in the chip package structure, the second barrier layer may be an annulus surrounding the window.

Optionally, in the chip package structure, the second barrier layer may be formed only on the first barrier layer in alignment with the street region and have a width measured along a surface of the substrate, which is less than a width of the street region.

Optionally, in the chip package structure, the second barrier layer may have a width measured along a surface of the substrate, which is greater than or equal to 50 µm.

Optionally, in the chip package structure, boundaries of the second barrier layer closer to the window may be aligned with boundaries of the first barrier layer closer to the window.

Optionally, in the chip package structure, a surface of the non-filter chip closer to the substrate may be lower than, flush with or higher than the surface of second barrier layer.

Optionally, in the chip package structure, the second barrier layer may be made of the same material as the first barrier layer.

Optionally, in the chip package structure, the first and second barrier layers may be both solder mask layers.

Optionally, in the chip package structure, there may be one or more filter chips and one or more non-filter chips, wherein there are respective one or more filtering bearing regions and respective one or more non-filtering bearing regions.

The present invention also provides a chip package method including:
providing a substrate defining a filtering bearing region, a non-filtering bearing region and a street region surrounding the filtering bearing region and the non-filtering bearing region, the substrate formed thereon with a first solder pad and a second solder pad, the first solder pad located in the filtering bearing region, the second solder pad located in the non-filtering bearing region;
forming a first barrier layer on the substrate and a window and an opening in the first barrier layer, both of which extend through the first barrier layer across its thickness, the window exposing the substrate and the second solder pad in the non-filtering bearing region, as well as the substrate in a portion of the street region around the non-filtering bearing region, the opening exposing the first solder pad;
forming a second barrier layer on the first barrier layer in close proximity to an edge of the window;
attaching a filter chip in the filtering bearing region, which includes a first substrate, an interdigital transducer (IDT) formed on the first substrate and a first bump formed on the first substrate, so that the IDT faces the first barrier layer and the first bump is electrically connected to the first solder pad, with a first hollow cavity being formed below the filter chip;
attaching a non-filter chip in the non-filtering bearing region, which includes a second substrate and a second bump formed on the second substrate, so that the second bump is electrically connected to the second solder pad, with a second hollow cavity being formed under the non-filter chip so as to communicate with the window;
applying a covering film onto surfaces of the filter chip and the non-filter chip and the first and second barrier layers so that it encloses the first hollow cavity, and tearing the covering film open along an interface of the second barrier layer and the window, thereby forming a break there; and
forming a plastic packaging layer, which covers a surface of the covering film and penetrates through the break to fill the window and the second hollow cavity.

Optionally, in the chip package method, the break may be formed in the covering film using a laser beam.

Optionally, in the chip package method, the plastic packaging layer may be formed under a reduced pressure lower than 4 T.

As noted above, the present invention provides a chip package structure and a chip package method, in which a window in a first barrier layer exposes a substrate and a second solder pad in a non-filtering bearing region, as well as the substrate in a portion of a street region around the non-filtering bearing region, and a second barrier layer is formed on the first barrier layer in close proximity to an edge of the window. With this arrangement, a covering film is allowed to enclose a first hollow cavity under a filter chip while being able to be easily torn open along an interface of the second barrier layer and the window, resulting in the formation of a break therein, through which a plastic packaging layer can penetrate to fill the window and a second hollow cavity under a non-filter chip. This not only ensures proper operation of the filter chip, but also overcomes the problem of degraded reliability of the other device caused by insufficient underfilling by the encapsulating material, resulting in increased reliability of the chip package structure.

### BRIEF DESCRIPTION OF THE DRAWINGS

Fig. 1 shows a schematic flowchart of a chip package method according to an embodiment of the present invention.
Fig. 2 shows a schematic cross-sectional view of a structure resulting from the formation of a first barrier layer and a second barrier layer according to an embodiment of the present invention.
Fig. 3 shows a schematic top view of a structure resulting from the formation of a first barrier layer and a second barrier layer according to an embodiment of the present invention.
Fig. 4 shows a schematic cross-sectional view of a structure resulting from the attachment of a filter chip and a non-filter chip according to an embodiment of the present invention.
Fig. 5 shows a schematic cross-sectional view of a structure resulting from the application of a covering film according to an embodiment of the present invention.
Fig. 6 shows a schematic cross-sectional view of a chip package structure according to an embodiment of the present invention.

### List of Reference Numerals

10 chip package structure; 100 substrate; 110 filtering bearing region; 120 non-filtering bearing region; 130 street region; 140 first solder pad; 150 second solder pad; 200 first barrier layer; 210 window; 220 opening; 300 second barrier layer; 400 filter chip; 410 first substrate; 420 IDT; 430 first bump; 440 first hollow cavity; 500 non-filter chip than filter chip; 510 second substrate; 520 second bump; 530 second hollow cavity; 600 covering film; 610 break; 700 plastic packaging layer;
H distance; W width.

### DETAILED DESCRIPTION

Chip package structures and chip package methods proposed in specific embodiments of the present invention will be described in greater detail below with reference to the accompanying drawings. From the following description, advantages and features of the present invention will become more apparent. Note that the figures are provided in a very simplified form not necessarily drawn to exact scale for the only purpose of facilitating easy and clear description of the embodiments disclosed herein.

The terminology used herein is for the purpose of describing particular embodiments only and is not intended to be limiting of the invention. Unless defined otherwise herein, all technical and scientific terms used herein have the same meaning as commonly understood by one of ordinary skill in the art to which the invention belongs. As used herein and in the appended claims, the terms "first," "second," and the like do not denote any order, quantity, or importance, but rather are used to distinguish one element from another. Likewise, the terms "a", "an" and the like do not denote a limitation of quantity, but rather denote the presence of at least one of the referenced items. The terms "plurality" or "several" means two or more than two. Unless defined otherwise herein, the terms "upper", "upper layer", "lower", "lower layer" and/or the like are merely for ease of description, and should not be construed as being limited to a particular position, or to a particular spatial orientation. The use of "including" or "comprising" or the like herein is meant to encompass the elements or items listed thereafter and equivalents thereof but do not preclude the presence of other elements or items. The terms "connected", "coupled" or the like are not restricted to physical or mechanical connections or couplings, and can include electrical connections or couplings, whether direct or indirect. As used herein and in the appended claims, the singular forms "a", "an", and "the" are intended to include the plural forms as well, unless the context clearly indicates otherwise. It will be also understood that, as used herein, the term "and/or" includes any and all combinations of one or more of the associated listed items.

In principle, the present invention seeks to provide a chip package structure and a chip package method, in which a window in a first barrier layer exposes a substrate and a second solder pad in a non-filtering bearing region, as well as the substrate in a portion of a street region around the non-filtering bearing region, and a second barrier layer is formed on the first barrier layer in close proximity to an edge of the window. With this arrangement, a covering film is allowed to enclose a first hollow cavity under a filter chip while being able to be easily torn open along an interface of the second barrier layer and the window, resulting in the formation of a break therein, through which a plastic packaging layer can penetrate to fill the window and a second hollow cavity under a non-filter chip. This not only ensures proper operation of the filter chip, but also overcomes the problem of degraded reliability of the other device caused by insufficient underfilling by the encapsulating material, resulting in increased reliability of the chip package structure.

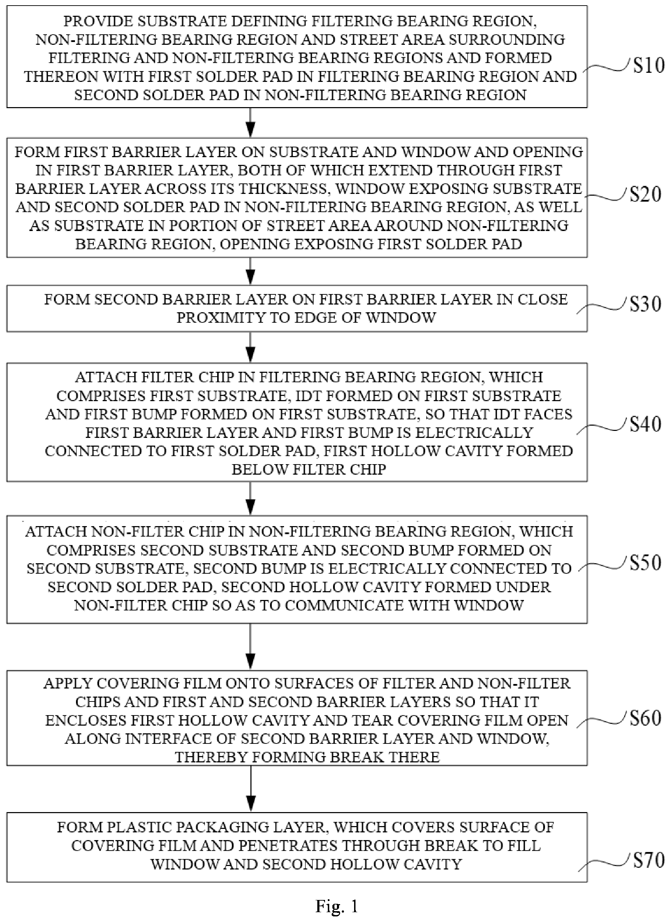

Reference is now made to Fig. 1, which shows a schematic flowchart of a chip package method according to an embodiment of the present invention. As shown in Fig. 1, a chip package method according to an embodiment disclosed herein includes the steps of:
S10) providing a substrate defining a filtering bearing region, a non-filtering bearing region and a street region surrounding the filtering bearing region and the non-filtering bearing region, the substrate formed thereon with a first solder pad and a second solder pad, the first solder pad located in the filtering bearing region, the second solder pad located in the non-filtering bearing region;
S20) forming a first barrier layer on the substrate and a window and an opening in the first barrier layer, both of which extend through the first barrier layer across its thickness, the window exposing the substrate and the second solder pad in the non-filtering bearing region, as well as the substrate in a portion of the street region around the non-filtering bearing region, the opening exposing the first solder pad;
S30) forming a second barrier layer on the first barrier layer in close proximity to an edge of the window;
S40) attaching a filter chip in the filtering bearing region, which includes a first substrate, an interdigital transducer (IDT) formed on the first substrate and a first bump formed on the first substrate, so that the IDT faces the first barrier layer and the first bump is electrically connected to the first solder pad, with a first hollow cavity being formed below the filter chip;
S50) attaching a non-filter chip in the non-filtering bearing region, which includes a second substrate and a second bump formed on the second substrate, so that the second bump is electrically connected to the second solder pad, with a second hollow cavity being formed under the non-filter chip so as to communicate with the window;
S60) applying a covering film onto surfaces of the filter chip and the non-filter chip and the first and second barrier layers so that it encloses the first hollow cavity, and tearing the covering film open along an interface of the second barrier layer and the window, thereby forming a break there; and
S70) forming a plastic packaging layer, which covers a surface of the covering film and penetrates through the break to fill the window and the second hollow cavity.

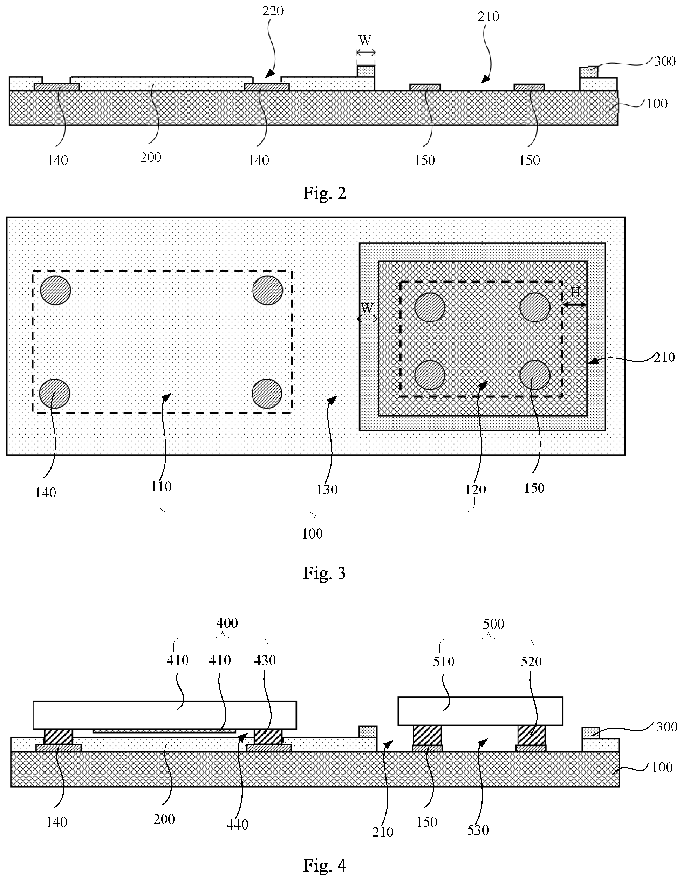

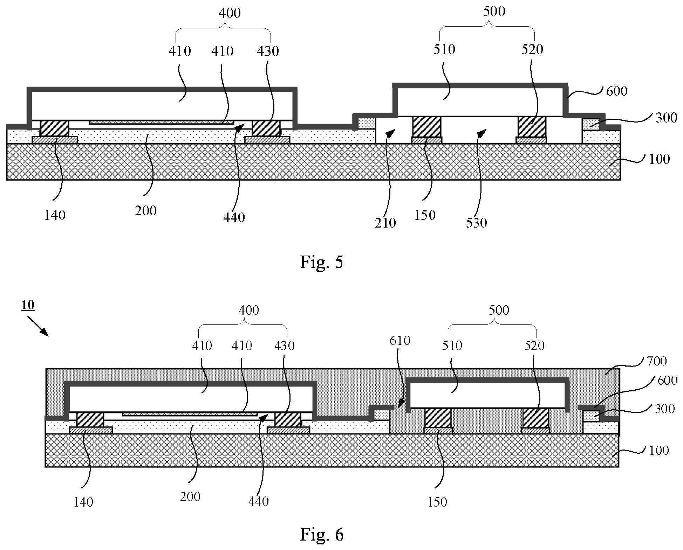

Reference is also made to Figs. 2 to 6. Fig. 2 shows a schematic cross-sectional view of a structure resulting from the formation of a first barrier layer and a second barrier layer according to an embodiment of the present invention. Fig. 3 shows a schematic top view of a structure resulting from the formation of a first barrier layer and a second barrier layer according to an embodiment of the present invention. Fig. 4 shows a schematic cross-sectional view of a structure resulting from the attachment of a filter chip and a non-filter chip according to an embodiment of the present invention. Fig. 5 shows a schematic cross-sectional view of a structure resulting from the application of a covering film according to an embodiment of the present invention. Fig. 6 shows a schematic cross-sectional view of a chip package structure according to an embodiment of the present invention.

As shown in Fig. 2, according to an embodiment disclosed herein, first of all, a substrate 100 is provided, the substrate 100 may be made of, for example, a semiconductor, resin, ceramic, glass, etc. The substrate 100 defines a filtering bearing region 110 for carrying a filter chip, a non-filtering bearing region 120 for carrying a non-filter chip and a street region 130 surrounding the filtering bearing region and the non-filtering bearing region 110, 120. According to an embodiment disclosed herein, the filtering bearing region 110 is separated from the non-filtering bearing region 120 by the street region 130. Both the filtering bearing region and the non-filtering bearing region 110, 120 are located within the street region 130. This not only ensures that a filter or non-filter chip can be subsequently attached in an easy and more reliable way, but also facilitates the covering of surfaces of the filter chip and the non-filter chip with a subsequently formed plastic packaging layer, providing better protection for the filter chip and the non-filter chip.

The substrate 100 may define one or more filtering bearing regions 110 for attachment of respective one or more filter chips. Similarly, the substrate 100 may define one or more non-filtering bearing regions 120 for attachment of respective one or more non-filter chips.

The filtering bearing region 110 may be identical to a projection of a filter chip to be attached to the substrate 100 therein; or the filtering bearing region 110 may be greater than a projection of a filter chip to be attached to the substrate 100 therein. That is, each of boundaries of the projection of the filter chip on the substrate 100 may coincide with a respective one of respective boundaries of the filtering bearing region 110, or be encompassed within the filtering bearing region 110. Likewise, the non-filtering bearing region 120 may be identical to, or greater than, a projection of a non-filter chip to be attached to the substrate 100 therein. That is, each of boundaries of the projection of the non-filter chip on the substrate 100 may coincide with a respective one of respective boundaries of the non-filtering bearing region 120, or be encompassed within the non-filtering bearing region 120. According to an embodiment disclosed herein, the filtering bearing region 110 is identical to a projection of a filter chip to be attached to the substrate 100 therein. That is, the two coincide with each other. Additionally, the non-filtering bearing region 120 is identical to a projection of a non-filter chip to be attached to the substrate 100 therein. That is, the two coincide with each other.

With continued reference to Fig. 2, according to an embodiment disclosed herein, there are a first solder pad 140 and a second solder pad 150 on the substrate 100. The first solder pad 140 is formed in the filtering bearing region 110, and the second solder pad 150 is formed in the non-filtering bearing region 120. In case of the substrate 100 defining more than one filtering bearing region 110, there is a first solder pad 140 in each filtering bearing region 110. In case of the substrate 100 defining more than one non-filtering bearing region 120, there is a second solder pad 150 in each non-filtering bearing region 120. Both the first and second solder pads 140, 150 are metal pads, for example, the first and second solder pads 140, 150 are tin pads. There may be a plurality of first solder pads 140 in each filtering bearing region 110, which may be arranged in any desired manner. There may be a plurality of second solder pads 150 in each non-filtering bearing region 120, which may be arranged in any desired manner. However, the present application is not so limited.

With additional reference to Fig. 3, according to an embodiment disclosed herein, both the first and second solder pads 140, 150 are circular in shape. According to alternative embodiments disclosed herein, they may have a different shape, such as rectangular. In the illustrated embodiment, there are four first solder pads 140 in the filtering bearing region 110, which are arranged at the corners of a rectangle. Moreover, there are four second solder pads 150 in the non-filtering bearing region 120, which are also arranged at the corners of a rectangle. According to alternative embodiments disclosed herein, the first and second solder pads 140, 150 may be arranged in different manners, without limiting the present application in any sense.

With continued reference to Fig. 2, a first barrier layer 200 is then formed in the substrate 100, and a window 210 and an opening 220 in the first barrier layer 200, both extending through the first barrier layer 200 across its entire thickness. The window 210 exposes the substrate 100 and the second solder pad 150 in the non-filtering bearing region 120, as well as the substrate 100 in a portion of the street region 130 around the non-filtering bearing region 120. The opening 220 exposes the first solder pad 140. Thus, the window 210 is larger than the non-filtering bearing region 120. According to an embodiment disclosed herein, all the boundaries of the non-filtering bearing region 120 are encompassed in the window 210.

Further, referring to Fig. 3, in case of a single non-filtering bearing region 120, one corresponding window 210 is formed. In case of the substrate 100 defining a plurality of non-filtering bearing regions 120, a plurality of windows 210 are formed in the first barrier layer 200, the plurality of windows 210 correspond to the respective non-filtering bearing regions 120. Preferably, each window 210 exposes all the second solder pad(s) 150 in the respective non-filtering bearing region 120.

Preferably, at least one of boundaries of the window 210 is spaced from respective one(s) of the boundaries of the non-filtering bearing region 120 at a distance H greater than or equal to 10 µm. More preferably, each of the boundaries of the window 210 is spaced from a respective one of the boundaries of the non-filtering bearing region 120 at a distance H greater than or equal to 10 µm. As shown in Fig. 3, according to an embodiment disclosed herein, both the non-filtering bearing region 120 and the window 210 are rectangular. The boundaries of the window 210 may be spaced from the respective boundaries of the non-filtering bearing region 120 at the same or different distances. According to an embodiment disclosed herein, the boundaries of the window 210 are spaced from the respective boundaries of the non-filtering bearing region 120 at the same distance.

According to alternative embodiments disclosed herein, at least one boundary of the window 210 may be spaced from the respective boundary(ies) of the non-filtering bearing region 120 at a distance H, as required by a subsequently formed covering film and plastic packaging layer. Specifically, assuming that the covering film to be formed has a thickness of H1 and the plastic packaging layer to be formed contains filler particles with a particle size of H2, then at least one boundary of the window 210 may be spaced from the respective one(s) of the boundaries of the non-filtering bearing region 120 at a distance H, which is greater than or equal to H1 + 2H2. With this arrangement of the boundaries, passage of filler particles in the plastic packaging layer is allowed, facilitating subsequent filling of the plastic packaging layer into a space under a non-filter chip.

As shown in Figs. 2 and 3, in the illustrated embodiment, a plurality of openings 220 are formed, each exposing one of the first solder pads 140. More specifically, each opening 220 may expose the entirely or part of one of the first solder pads 140. According to an embodiment disclosed herein, what is exposed in each opening 220 is only the entirely or part of one of the first solder pads 140.

According to a specific embodiment disclosed herein, at first, a first barrier material layer (not shown) may be formed, which covers the entirety of an upper surface of the substrate 100. Next, unwanted portions of the first barrier material layer may be removed by performing semiconductor processes thereon, such as etching and ashing, thereby obtaining the first barrier layer 200 with the window 210 and the opening 220. Preferably, the first barrier layer 200 is a solder mask layer. According to alternative embodiments disclosed herein, the first barrier layer 200 may be a different material, such as a dielectric material.

As shown in Fig. 2, a second barrier layer 300 is formed on the first barrier layer 200, the second barrier layer 300 is formed in close proximity to edges of the window 210. According to an embodiment disclosed herein, the second barrier layer 300 is an annulus surrounding the window 210. In the illustrated embodiment, the second barrier layer 300 is formed as a rectangular annulus. According to alternative embodiments disclosed herein, the second barrier layer 300 may have different shapes. For example, the second barrier layer 300 may be irregularly shaped and define a window aligned with the window 210. Boundaries of the second barrier layer 300 may extend entirely above the first barrier layer 200 in the street region 130, or partly above the first barrier layer 200 in the filtering bearing region 110, without limiting the present application.

According to an embodiment disclosed herein, the second barrier layer 300 is formed only on the first barrier layer 200 in alignment with the street region 130 and has a width W measured along the surface of the substrate 100, which is less than a width of the encompassed street region 130. That is, the second barrier layer 300 is formed only on a portion of the first barrier layer 200 in the street region 130 and is closer to the non-filtering bearing region 120 than to the filtering bearing region 110. The width W of the second barrier layer 300 measured along the surface of the substrate 100 is greater than or equal to 50 µm. This can enhance adhesion of the second barrier layer 300 to the first barrier layer 200.

With continued reference to Fig. 2, according to an embodiment disclosed herein, boundaries of the second barrier layer 300 closer to the window 210 are aligned with boundaries of the first barrier layer 200 closer to the window 210. This allows for a lager contact area, and hence increased adhesion, between the second and first barrier layers 300, 200.

According to alternative embodiments disclosed herein, the boundaries of the second barrier layer 300 closer to the window 210 may be located backwardly or forwardly beyond the boundaries of the first barrier layer 200 closer to the window 210.

In case of the boundaries of the second barrier layer 300 closer to the window 210 being located backwardly beyond the boundaries of the first barrier layer 200 closer to the window 210, a portion of the first barrier layer 200 adjacent to the window 210 is exposed from the second barrier layer 300. Preferably, the portion of the first barrier layer 200 adjacent to the window 210 that is exposed from the second barrier layer 300 has a less cross-sectional width than the second barrier layer 300.

In case of the boundaries of the second barrier layer 300 closer to the window 210 being located forwardly beyond the boundaries of the first barrier layer 200 closer to the window 210, it has a first portion (not shown) projecting beyond the first barrier layer 200 and a second portion (not shown) residing on the first barrier layer 200. The first portion may have a cross-sectional width less than that of the second portion. This can ensure a sufficient contact area, and hence adequate adhesion, between the second and first barrier layers 300, 200. Further, in this case, projections of the boundaries of the second barrier layer 300 closer to the window 210 on the substrate 100 may also be spaced from the respective boundaries of the non-filtering bearing region 120 at a distance, which is greater than or equal to 10 µm, or greater than or equal to H1 + 2H2, in order to facilitate subsequent filling of a plastic packaging layer into a space under a non-filter chip.

According to an embodiment disclosed herein, the second barrier layer 300 may be a solder mask layer, for example, made of the composition commonly known as "green oil". Preferably, the first barrier layer 200 is also a solder mask layer, for example, made of the composition commonly known as "green oil". This can additionally enhance the adhesion between the second and first barrier layers 300, 200, improving the quality and reliability of the resulting chip package structure.

Preferably, the second barrier layer 300 has a thickness equal to that of the first barrier layer 200; or the second barrier layer 300 has a thickness greater than that of the first barrier layer 200. This allows a subsequently applied covering film to be more easily torn open along an interface of the second barrier layer and the window.

Next, referring to Fig. 4, a filter chip 400 is attached in the filtering bearing region 110, and annon-filter chip 500 than a filter chip is attached in the non-filtering bearing region 120. The attachment of the filter chip 400 to the filtering bearing region 110 precedes the attachment of the non-filter chip 500 to the non-filtering bearing region 120; or the attachment of the filter chip to the filtering bearing region concurs with the attachment of the non-filter chip 500 to the non-filtering bearing region 120; or the attachment of the filter chip to the filtering bearing region succeeds the attachment of the non-filter chip 500 to the non-filtering bearing region 120.

Specifically, the filter chip 400 includes a first substrate 410, an interdigital transducer (IDT) 420 formed on the first substrate 410 and a first bump 430 formed on the first substrate 410. The first bump 430 and the IDT 420 are located on the same surface of the first substrate 410. As a result of the attachment, the IDT 420 faces the first barrier layer 200, and the first bump 430 is electrically connected to the first solder pad 140, with a first hollow cavity 440 being formed under the filter chip 400. The first bump 430 is a metal bump, for example, the first bump 430 is in the form of a copper post, a gold ball, a tin ball or the like. The first bump 430 may be soldered and thus electrically connected to the first solder pad 140.

Preferably, the first hollow cavity 440 has a height less than or equal to 20 µm, leading the IDT 420 being spaced apart from the first barrier layer 200 at a distance greater than 0 µm and less than or equal to 20 µm. Forming the hollow cavity in this way not only enables more reliable attachment of the filter chip 400 to the substrate 100, but can also facilitate miniaturization of the resulting chip package structure.

The non-filter chip 500 includes a second substrate 510 and a second bump 520 formed on the second substrate 510. As a result of the attachment, the second bump 520 is electrically connected to the second solder pad 150, with a second hollow cavity 530 being formed under the non-filter chip 500, the window 210communicates with the second hollow cavity 530. According to an embodiment disclosed herein, the window 210 encompasses the second hollow cavity 530. More specifically, a projection of the second hollow cavity 530 on the substrate 100 is encompassed within a projection of the window 210 on the substrate 100.

The second bump 520 is a metal bump, for example, the second bump 520 is in the form of a copper post, a gold ball, a tin ball or the like. The second bump 520 may be soldered and thus electrically connected to the second solder pad 150. Without limiting the present application, the non-filter chip 500 may be a common component operating without depending on a hollow cavity, such as an antenna switch, a low-noise amplifier (LNA), a capacitor, an inductor or the like.

A lower surface of the non-filter chip 500 that is closer to the substrate 100 may be lower than, flush with or higher than an upper surface of the second barrier layer 300. In particular, for example, a height of the second bump 520 may be changed to modify the level of the lower surface of the non-filter chip 500 relative to the upper surface of the second barrier layer 300. Alternatively, this may also be accomplished by changing a height of the second solder pad 150, the thickness of the first or second barrier layer 200, 300, or otherwise.

After that, as shown in Fig. 5, a covering film 600 is applied to cover the whole structure. More specifically, the ape 600 covers surfaces of the filter chip 400, the non-filter chip 500, the first barrier layer 200 and the second barrier layer 300, and the ape 600 encloses the first hollow cavity 440. For example, the covering film 600 may be a polyimide (PI)- or epoxy-based dry film. Preferably, the covering film 600 has a thickness not less than the height of the first hollow cavity 440. More preferably, the thickness of the covering film 600 is equal to the height of the first hollow cavity 440. This can not only ensure stability of the first hollow cavity 440, but also allows the covering film to be torn open around the window 210.

With additional reference to Figs. 5 and 6, according to an embodiment disclosed herein, a break 610 is formed in the covering film 600, the break 610 is formed along an interface of the second barrier layer 300 and the window 210.

According to an embodiment disclosed herein, the break 610 may be formed by leveraging deformation of the covering film 600. Specifically, since the second barrier layer 300 is formed on the first barrier layer 200 in close proximity to the edges of the window 210, the covering film 600 may be applied so as to be stretched and thinned along the interface of the second barrier layer 300 and the window 210. This thinner portion of the covering film 600 can be more easily torn open, thereby forming the break.

According to an embodiment disclosed herein, the break 610 may be formed in the covering film 600 using a laser beam. The break 610 is aligned with a gap between the second barrier layer 300 and the non-filter chip 500 along the interface of the second barrier layer 300 and the window 210. Using a laser beam enables rapid, accurate formation of the break 610. Alternatively, multiple breaks 610 may be formed around the non-filter chip 500 to facilitate subsequent underfilling by a plastic packaging layer.

Referring to Fig. 6, a plastic packaging layer 700 is then formed over the covering film 600, the plastic packaging layer 700 penetrates through the break 610 to fill the window 210 and the second hollow cavity 530 between the non-filter chip 500 and the substrate 100, without inadequate filling of the cavity under the non-filter chip by the encapsulating material, which is detrimental to reliability, thus enhancing the reliability of the resulting chip package structure.

Preferably, the plastic packaging layer 700 is formed under a reduced pressure lower than 4 T. This allows the plastic packaging layer 700 to fill the space under the non-filter chip 500 in a desired way, while well maintaining the first hollow cavity 440 enclosed, enhancing the quality and reliability of the resulting chip package structure 10.

With continued reference to Fig. 6, embodiments disclosed herein also provide a chip package structure 10, the chip package structure 10 includes: a substrate 100, the substrate 100 defining a filtering bearing region 110, a non-filtering bearing region 120 and a street region 130 surrounding the filtering bearing region and the non-filtering bearing region 110, 120, the substrate 100 formed thereon with a first solder pad 140 and a second solder pad 150, the first solder pad 140 located in the filtering bearing region 110, the second solder pad 150 located in the non-filtering bearing region 120; a first barrier layer 200 formed on the substrate 100, the first barrier layer 200 formed therein with a window 210 and an opening 220, both extending through it across its thickness, the window 210 exposing the substrate 100 and the second solder pad 150 in the non-filtering bearing region 120, as well as the substrate 100 in a portion of the street region 130 around the non-filtering bearing region 120, the opening 220 exposing the first solder pad 140; a second barrier layer 300 formed on the first barrier layer 200 in close proximity to an edge of the window 210; a filter chip 400 aligned with the filtering bearing region 110, which includes a first substrate 410, an IDT 420 formed on the first substrate 410 and a first bump 430 formed on the first substrate 410, and under which there is a first hollow cavity 440, the IDT 420 facing the first barrier layer 200, the first bump 430 electrically connected to the first solder pad 140, annon-filter chip 500 than a filter chip aligned with the non-filtering bearing region 120, which includes a second substrate 510 and a second bump 520 formed on the second substrate 510, and under which there is a second hollow cavity 530, the second bump 520 electrically connected to the second solder pad 150, the second hollow cavity 530 in communication with the window 210; a covering film 600, which covers surfaces of the filter chip and the non-filter chip 400, 500 and the first and second barrier layers 200, 300 so as to enclose the first hollow cavity 440, and in which a break 610 is formed in close proximity to the window 210; and a plastic packaging layer 700, which covers a surface of the covering film 600 and penetrates through the break 610 to fill the window 210 and the second hollow cavity 530.

In addition, a projection of the non-filter chip 500 on the substrate 100 may coincide with the non-filtering bearing region 120, and boundaries of the window 210 may be spaced from respective boundaries of the non-filtering bearing region 120 at a distance H greater than or equal to 10 µm. Alternatively, at least one of the boundaries of the window 210 may be spaced from a respective at least one of the respective boundaries of the non-filtering bearing region 120 at a distance H greater than or equal to H1 + 2H2, where H1 represents a thickness of the covering film 600, and H2 represents a particle size of particles in the plastic packaging layer 700.

Preferably, the second barrier layer 300 is an annulus surrounding the window 210. The second barrier layer 300 may be formed only on the first barrier layer 200 in alignment with the exposed street region 130. The second barrier layer 300 has a width W measured along the surface of the substrate 100, which is less than a width of the encompassed street region 130. The width W of the second barrier layer 300 measured along the surface of the substrate 100 may be greater than or equal to 50 µm.

Boundaries of the second barrier layer 300 closer to the window 210 may be aligned with boundaries of the first barrier layer 200 closer to the window 210. Alternatively, the boundaries of the second barrier layer 300 closer to the window 210 may be located backwardly or forwardly beyond the boundaries of the first barrier layer 200 closer to the window 210.

As discussed above, the present invention provides a chip package structure and a chip package method, in which a window in a first barrier layer exposes a substrate and a second solder pad in a non-filtering bearing region, as well as the substrate in a portion of a street region around the non-filtering bearing region, and a second barrier layer is formed on the first barrier layer in close proximity to an edge of the window. With this arrangement, a covering film is allowed to enclose a first hollow cavity under a filter chip while being able to be easily torn open along an interface of the second barrier layer and the window, resulting in the formation of a break therein, through which a plastic packaging layer can penetrate to fill the window and a second hollow cavity under a non-filter chip. This not only ensures proper operation of the filter chip, but also overcomes the problem of degraded reliability of the other device caused by insufficient underfilling by the encapsulating material, resulting in increased reliability of the chip package structure.

As used herein, any reference to "one embodiment" or "some embodiments" means that a particular feature, structure, or characteristic described in connection with the embodiment is included in at least one embodiment or at least some embodiments disclosed herein. Therefore, the appearances of the phrase "in one embodiment" or "in some embodiments" in various places in the specification are not necessarily all referring to the same one or some embodiments. Further, in one or more embodiments, features, structures or characteristics may be combined in any suitable combination and/or sub-combination.

While a few particular embodiments of the present application have been described in detail by way of examples, those skilled in the art will understand that the foregoing examples are provided for illustration only rather than any limitation on the scope of the application. The various embodiments disclosed herein can be combined in any combination, without departing from the spirit and scope of the application. Those skilled in the art will also understand that various modifications can be made to the embodiments, without departing from the scope and spirit of the application. The scope of the application is defined by the appended claims.

## Claims

1. A chip package structure, **characterized in that**, the chip package structure comprises:
a substrate defining a filtering bearing region, a non-filtering bearing region and a street region surrounding the filtering bearing region and the non-filtering bearing region, a first solder pad and a second solder pad formed on the substrate, the first solder pad located in the filtering bearing region, and the second solder pad located in the non-filtering bearing region;
a first barrier layer formed on the substrate, the first barrier layer formed therein with a window and an opening extending in a thickness direction, the window exposing the substrate and the second solder pad in the non-filtering bearing region, as well as the substrate in a portion of the street region around the non-filtering bearing region, the opening exposing the first solder pad;
a second barrier layer formed on the first barrier layer, wherein the second barrier layer is located at an edge position of the first barrier layer close to the window;
a filter chip aligned with the filtering bearing region, which comprises a first substrate, an interdigital transducer formed on the first substrate and a first bump formed on the first substrate, the interdigital transducer facing the first barrier layer, the first bump electrically connected to the first solder pad, and a first hollow cavity formed under the filter chip;
a non-filter chip aligned with the non-filtering bearing region, which comprises a second substrate and a second bump formed on the second substrate, the second bump electrically connected to the second solder pad, a second hollow cavity formed under the non-filter chip, the window in communication with the second hollow cavity;
a covering film covering surfaces of the filter chip, the non-filter chip and the first barrier layer and the second barrier layer, wherein the covering film encloses the first hollow cavity and is broken at a position of the second barrier layer close to the window to form a break; and
a plastic packaging layer covering a surface of the covering film, wherein the plastic packaging layer further fills the window and the second hollow cavity through the break.

2. The chip package structure of claim 1, wherein the covering film has a thickness of H1 and particles in the plastic packaging layer have a particle size of H2, wherein a projection of the non-filter chip on the substrate coincides with the non-filtering bearing region, and wherein at least one boundary of the window is spaced from respective at least one boundary of the non-filtering bearing region at a distance greater than or equal to H1 + 2H2.

3. The chip package structure of claim 1, wherein a projection of the non-filter chip on the substrate coincides with the non-filtering bearing region, wherein at least one boundary of the window is spaced from respective at least one boundary of the non-filtering bearing region at a distance greater than or equal to 10 µm.

4. The chip package structure of claim 1, wherein the second barrier layer is an annulus surrounding the window.

5. The chip package structure of claim 1, wherein the second barrier layer is formed only on the first barrier layer in alignment with the street region, and wherein a width of the second barrier layer along a surface of the substrate is less than a width of the street region.

6. The chip package structure of claim 1, wherein a width of the second barrier layer along a surface of the substrate is greater than or equal to 50 µm.

7. The chip package structure of claim 1, wherein boundaries of the second barrier layer closer to the window are aligned with boundaries of the first barrier layer closer to the window.

8. The chip package structure of any one of claims 1 to 7, wherein the surface of the non-filter chip closer to the substrate is lower than, flush with or higher than the surface of second barrier layer.

9. The chip package structure of any one of claims 1 to 7, wherein the second barrier layer is made of the same material as the first barrier layer.

10. The chip package structure of any one of claims 1 to 7, wherein the first barrier layer and the second barrier layer are both solder mask layers.

11. The chip package structure of any one of claims 1 to 7, wherein the second and first barrier layers are made of different materials.

12. The chip package structure of any one of claims 1 to 7, wherein there are one or more filter chips and one or more non-filter chips, and wherein there are respective one or more filtering bearing regions and respective one or more non-filtering bearing regions.

13. A chip package method, **characterized in that**, the chip package method comprises:
providing a substrate defining a filtering bearing region, a non-filtering bearing region and a street region surrounding the filtering bearing region and the non-filtering bearing region, the substrate formed thereon with a first solder pad and a second solder pad, the first solder pad located in the filtering bearing region, and the second solder pad located in the non-filtering bearing region;
forming a first barrier layer on the substrate, the first barrier layer formed therein with a window and an opening extending in a thickness direction, the window exposing the substrate and the second solder pad in the non-filtering bearing region, as well as the substrate in a portion of the street region around the non-filtering bearing region, the opening exposing the first solder pad;
forming a second barrier layer on the first barrier layer, wherein the second barrier layer is located at an edge position of the first barrier layer close to the window;
attaching a filter chip in the filtering bearing region, which comprises a first substrate, an interdigital transducer formed on the first substrate and a first bump formed on the first substrate, the interdigital transducer facing the first barrier layer, the first bump electrically connected to the first solder pad, and a first hollow cavity formed under the filter chip;
attaching a non-filter chip in the non-filtering bearing region, wherein the non-filter chip comprises a second substrate and a second bump formed on the second substrate, the second bump is electrically connected to the second solder pad, a second hollow cavity is formed under the non-filter chip, the window is in communication with the second hollow cavity;
applying a covering film onto surfaces of the filter chip, the non-filter chip, the first barrier layer and the second barrier layer, wherein the covering film encloses the first hollow cavity and is broken at a position of the second barrier layer close to the window to form a break; and
forming a plastic packaging layer covering a surface of the covering film, wherein the plastic packaging layer further fills the window and the second hollow cavity through the break.

14. The chip package method of claim 13, wherein the break is formed in the covering film using a laser beam.

15. The chip package method of claim 13, wherein the plastic packaging layer is formed by using a low-pressure plastic packaging process, and a pressure of the low-pressure plastic packaging process is less than 4 T.
